# DEMANDE DE BREVET EUROPEEN

(11) **EP 1 070 971 A1**
(43) Date de publication de la demande: **24.01.2001**
(21) Numéro de dépôt: 00401930.3
(22) Date de dépôt: 05.07.2000
(51) Int. Cl.: G02B 1/10, G02B 5/08, B60R 1/00, C23C 14/02, C23C 14/20

(54) **Procédé de traitement de surface de pièces optiques en matière plastique pour véhicule automobile**

(30) Priorité: 21.07.1999 FR 9909445
(71) Demandeur: VALEO VISION, 93012 Bobigny Cédex (FR)
(72) Inventeur: Brassier, Marc, 93012 Bobigny Cedex (FR)
(74) Mandataire: Lemaire, Marc

(57) **Abrégé**

L'invention concerne un procédé de traitement de surface de pièces (18) optiques en matière plastique pour véhicules automobiles, par dépôt sous vide à la surface des pièces (18), caractérisé par le fait que l'on dépose sous vide plusieurs matériaux, chacun conférant au dépôt formé sur la surface des pièces (18), une propriété spécifique.

## Description

L'invention concerne le domaine de la fabrication de pièces optiques pour l'éclairage ou la signalisation de véhicules automobiles.

Plus précisément, l'invention concerne un procédé de traitement de surfaces de pièces optiques pour véhicules automobiles, en matière plastique, par dépôt sous vide d'un matériau sur au moins une zone de ces surfaces.

Les matières plastiques sont de plus en plus utilisées pour la fabrication de pièces optiques de projecteurs ou feux de signalisation (glaces, réflecteurs, socles, écran, masque, support, etc.).

Les composants polymères des matières plastiques utilisées dans les applications d'éclairage et de signalisation, sont soumis à des contraintes thermiques de plus en plus fortes. Aussi, à des températures supérieures à 220°C, les pièces optiques composées de certains polymères subissent elles des dégradations et des déformations généralement incompatibles avec la qualité et la précision de surface requise pour ces pièces, en particulier lorsqu'elles interviennent dans la formation d'un faisceau lumineux.

Pour conserver une bonne tenue mécanique des pièces, même aux températures supérieures à 220°C, tout en respectant certaines contraintes économiques et de robustesse en termes d'exploitation des procédés de fabrication de ces pièces, on utilise des polymères spécifiques. Certains de ces polymères spécifiques, susceptibles d'être utilisés pour la fabrication de pièces optiques, tels que les polyesters non saturés thermodurcissables pour le moulage de prémixes ou compounds, aussi appelés composés BMC/UP (BMC étant l'acronyme de la terminologie anglosaxonne «Bulk Molding Compound » et « UP » désignant un polyester non saturé thermodurcissable), ont une tendance marquée à une extraction de composés volatils et de produits de dégradation. Cette extraction, aussi appelée dégazage, est fonction du temps et se produit d'autant plus que la température est élevée.

Les composés volatils dégazants sont susceptibles de condenser sur des surfaces optiques. Par exemple, lorsque la pièce optique qui dégaze est un réflecteur de projecteur, la condensation peut se produire sur les parties les moins chaudes de la glace de ce projecteur, produisant un ternissement indésirable de ces surfaces. Ce ternissement est connu sous le terme anglo-saxon de « fogging ».

De plus, la fabrication de certaines pièces optiques est effectuée par des procédés d'injection, dits « monomatière », de polymères alliés et/ou modifiés par l'incorporation de renforts minéraux sous forme de fibres. L'obtention de performances thermomécaniques et la recherche d'une réduction des coûts de matière et de procédé nécessitent de privilégier ces procédés d'injection monomatière qui permettent, en outre, avec un moyen flexible, de définir le procédé le plus robuste en termes d'exploitation. Mais la qualité optique des surfaces des pièces optiques ainsi obtenues est insuffisante.

On effectue alors un dépôt d'un vernis organique (photoniquement ou thermiquement réticulable) pour donner à ces surfaces la qualité spéculaire nécessaire.

Cependant, le dépôt d'un vernis pose certains problèmes :
- il augmente le coût de fabrication des pièces optiques ;
- il faut trouver des vernis résistants aux élévations de température ; de plus, lorsque leur coefficient de dilatation thermique diffère de celui de la pièce optique qu'il protège, il faut prévoir entre le vernis et cette pièce, une couche intermédiaire susceptible d'absorber les tensions mécaniques pouvant se produire lors des variations de température ; et
- certains vernis posent des problèmes d'adhésion aux surfaces des pièces optiques à protéger, ce qui nécessite parfois des traitements de surface tels que corona, flamage, plasma micro-ondes, préalablement au dépôt d'un vernis de ce type.

Par ailleurs, les sources lumineuses à haute performance utilisent des hautes tensions pour amorcer et entretenir une décharge électroluminescente. Ces sources sont fortement émettrices de rayonnements électromagnétiques. Les pièces optiques environnantes de la source elle-même doivent donc faire l'objet d'un blindage électromagnétique, afin de faire barrière aux rayonnements électromagnétiques émis par la source et respecter les normes en vigueur ou en voie de l'être.

Un but de l'invention est d'élargir la gamme des matières plastiques utilisées dans la fabrication de pièces optiques pour véhicules automobiles, tout en rendant cette fabrication économique par l'accès à des matières polymères courantes (dites de commodité), pour leur utilisation dans des applications hautement techniques.

Ce but est atteint grâce à un procédé de traitement de surface de pièces optiques en matière plastique pour véhicules automobiles, par dépôt sous vide à la surface des pièces, caractérisé par le fait que l'on dépose sous vide plusieurs matériaux, chacun conférant au dépôt formé sur la surface des pièces, une propriété spécifique.

Grâce au procédé selon l'invention, il est permis d'utiliser des matières polymères courantes, mais ayant une bonne tenue mécanique. Les propriétés spécifiques que l'on souhaite obtenir des pièces optiques, telles qu'un bon coefficient spéculaire, la capacité de former un blindage aux rayonnements électromagnétiques, la limitation du dégazage, etc., sont alors obtenues par un matériau déposé sous vide en surface des pièces.

Le dépôt sous vide, c'est à dire sous faible pression, permet de former des couches minces ou semi-épaisses. Les faibles quantités de matériau spécifique utilisées rendent le procédé selon l'invention économique.

Il permet également de réaliser des dépôts de plusieurs matériaux sans pour autant constituer des couches épaisses qui pourraient, par exemple, déformer les surfaces, comme c'est le cas en particulier lorsque la surface est facettée.

Avantageusement, un des matériaux conférant une propriété spécifique au dépôt formé sur la surface des pièces optiques, est :
- un polymère apte à améliorer la qualité spéculaire sur au moins une zone de la surface de la matière plastique, alors qu'un autre des matériaux comprend un métal apte à former une surface réflectrice de la lumière, cet autre matériau étant déposé sur au moins une zone de la surface où a été préalablement déposé ledit polymère ; ou
- un polymère apte à former une barrière au(x) composé(s) volatil(s) de la matière plastique ; ou bien encore
- un polymère apte à la fois à améliorer la qualité spéculaire d'au moins une zone de la surface de la matière plastique, et à former une barrière au(x) composé(s) volatil(s) de cette matière plastique, ce polymère étant directement déposé sur la matière plastique et directement recouvert d'un autre matériau comprenant un métal apte à former une surface réflectrice de la lumière sur ladite zone de la surface de la matière plastique.

Ces polymères comprennent avantageusement un composé compris dans la liste constituée par les organo-siliciés, les silazanes, les silanes, les hydrocarbures saturés, les hydrocarbures non saturés, les hydrocarbures aliphatiques, cycliques ou aromatiques, les hydrocarbures substitués par une fonction alcool, les hydrocarbures substitués par une fonction amine, ainsi que les mélanges de ceux-ci.

Ledit composé de la liste citée ci-dessus peut être déposé seul ou avec au moins un autre composé. Dans ce dernier cas, on dépose avantageusement un mélange d'au moins deux composés compris dans la liste constitué par les organo-siliciés, les silazanes, les silanes, les hydrocarbures saturés, les hydrocarbures non saturés, les hydrocarbures substitués par une fonction alcool, les hydrocarbures substitués par une fonction amine, et les mélanges de ceux-ci.

Ledit mélange est alors avantageusement composé de tétramethyldisiloxane (TDMSO) et d'hexamethyldisiloxane (HMDSO).

Si l'on veut conférer aux pièces optiques fabriquées selon le procédé conforme à la présente invention, une propriété de blindage aux rayonnements électromagnétiques émis par les lampes à décharge par exemple, on dépose avantageusement, selon ce procédé, au moins un matériau apte à constituer un blindage vis à vis des rayonnements électromagnétiques émis par ce type de lampe.

Ce matériau est avantageusement compris dans la liste constituée par le chrome, le nickel, l'aluminium, le cuivre, un mélange d'au moins deux de ces métaux et un alliage d'au moins deux de ces métaux.

Selon un mode de mise en oeuvre avantageux du procédé selon l'invention, on dépose simultanément, au moins deux matériaux apportant chacun une propriété spécifique, au dépôt formé sur la surface des pièces optiques.

Selon un autre mode de mise en oeuvre avantageux du procédé selon l'invention, on dépose successivement au moins deux matériaux apportant chacun une propriété spécifique, au dépôt formé sur la surface des pièces optiques.

On peut ainsi, pour former un blindage, avantageusement déposer successivement une couche de cuivre pour assurer une conductivité élevée du dépôt et une couche de chrome, pour assurer une protection contre la corrosion du cuivre.

Avantageusement, on dépose ensuite sur une zone différente de celle sur laquelle ont été réalisées les couches de cuivre et de chrome, mais présentant un recouvrement avec celle-ci, une couche d'aluminium.

Selon un autre aspect de l'invention, celle-ci est une pièce optique qui comporte une couche déposée sous vide, de blindage vis à vis d'un rayonnement électromagnétique, constituée de deux matériaux métalliques, l'un étant apte à former essentiellement une couche électriquement conductrice et l'autre étant apte essentiellement à protéger la couche électriquement conductrice de la corrosion.

Avantageusement aussi, cette pièce optique comporte une sous-couche d'un matériau polymère déposée sous vide directement sur la matière plastique, apte à améliorer la qualité spéculaire d'au moins une zone de la surface de la matière plastique, et une couche métallique apte à former une surface réflectrice de la lumière sur ladite zone de la surface de la matière plastique.

D'autres aspects, buts et avantages de l'invention apparaîtront à la lecture de la description détaillée qui suit. L'invention sera aussi mieux comprise à l'aide des références aux dessins sur lesquels :
- la figure 1 est une représentation schématique en coupe médiane verticale d'un réacteur pour la mise en oeuvre du procédé selon l'invention ;
- la figure 2 est une représentation schématique analogue à celle de la figure 1, d'un autre type de réacteur pour la mise en oeuvre du procédé conforme à la présente invention ;
- la figure 3 est une représentation schématique en coupe médiane, dans un plan parallèle à son axe optique, d'un réflecteur pour projecteur de véhicule automobile, réalisé grâce au procédé conforme à la présente invention ;
- la figure 4 est une représentation schématique en coupe médiane, longitudinale et verticale d'encore un autre type de réacteur pour la mise en oeuvre du procédé conforme à la présente invention ;
- la figure 5 est une représentation schématique en coupe transversale d'un tambour de réacteur pour la mise en oeuvre du procédé conforme à la présente invention ;
- la figure 6 est une représentation analogue à celle de la figure 5, d'un autre type de tambour pour réacteur pour la mise en oeuvre du procédé conforme à la présente invention ; et
- la figure 7 est une représentation analogue à celle de la figure 4, d'un autre réflecteur pour véhicule automobile, obtenue par le procédé conforme à la présente invention.

On va décrire ci-dessous plusieurs modes préférés de mise en oeuvre du procédé selon l'invention.

Selon le premier mode de mise en oeuvre, le procédé conforme à la présente invention consiste à réaliser un système de sous couche permettant d'obtenir des pièces optiques ayant un bon coefficient de réflexion spéculaire et protégées pour éviter le dégazage.

Selon ce premier mode, on réalise une pièce optique en polyester non saturé thermodurcissable par moulage de prémixes ou compounds (BMC). La pièce optique ainsi réalisée est alors placée dans un réacteur 1 de dépôt de polymère sous vide, en phase vapeur, assisté par plasma (PECVD). Cette pièce optique est, pour l'exemple décrit ci-dessous, un réflecteur pour projecteur de véhicule automobile. Le réacteur 1 est par exemple du type Leybold ® 1200.

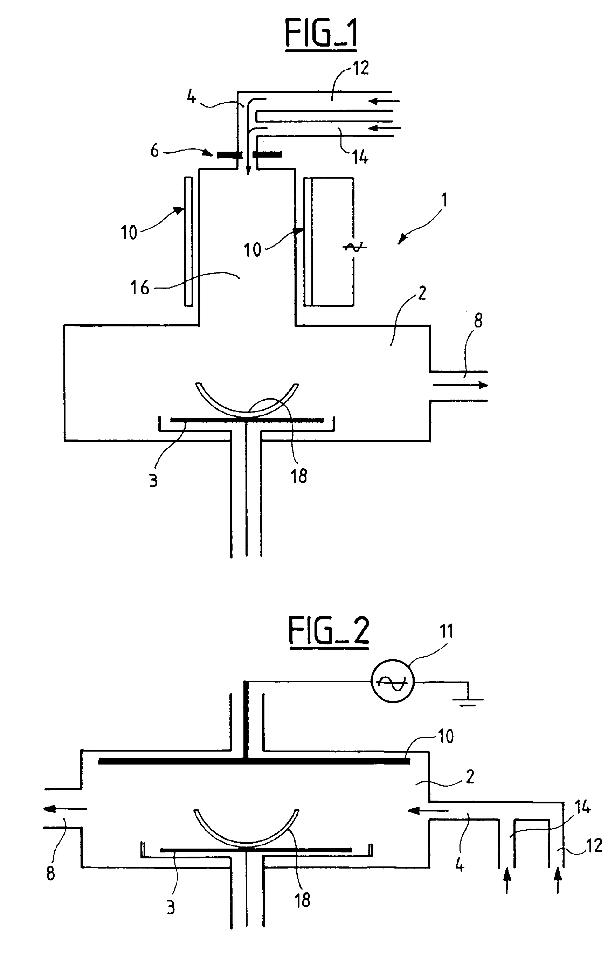

On a représenté schématiquement un réacteur 1 de ce type sur la figure 1. Ce réacteur est du type à plasma diffusé. Il comprend une chambre 2 de dépôt, un support 3 de pièces, une alimentation en gaz 4, une sortie 8 vers un système de pompage, et des électrodes 10.

L'alimentation en gaz 4 est reliée en amont de la chambre 2 à une arrivée de gaz vecteurs et de gaz plasmagène 12 et une arrivée de gaz monomères 14. Le gaz vecteur (aussi appelé gaz porteur) est de l'argon, le gaz plasmagène est de l'oxygène et les gaz monomères sont du tétramethyldisiloxane (TMDSO) et l'hexaméthyldisiloxane (HMDSO). Les débits de chacun de ces gaz sont 25 sccm pour l'argon, 25 sccm pour l'oxygène, 100 sccm pour le TMDSO et 100 sccm pour HMDSO. L'arrivée de tous ces gaz dans la chambre 2 est réglée par un débitmètre 6. Les gaz porteurs, plasmagènes ou diluants sont utiles pour maîtriser le débit, la pression, la concentration en monomère et son temps de séjour dans le réacteur 1, afin de contrôler le procédé. Les électrodes 10 placées à proximité de l'alimentation 4, dans une zone de décharge 16, constituent un couplage capacitif, alimenté en courant alternatif, non pulsé, avec une fréquence de 13,6 MHz. Le dépôt est effectué en post-décharge, c'est à dire par plasma diffusé. Le support 3 est en aval de la zone de décharge 16 par rapport à l'alimentation de gaz 4. Une pièce optique 18 est placée sur le support 3 et un vide est réalisé dans la chambre 2. La pièce optique 18 est par exemple un réflecteur pour projecteur de véhicule automobile en polymère tel que du BMC/UP.

Au cours d'une première étape, durant 5 secondes, l'argon sous un débit de 10 sccm, et de l'oxygène, sous un débit de 10 sccm sont introduits dans la chambre 2 pour amorcer le plasma radiofréquence, hyperfréquence ou micro-ondes.

Au cours d'une deuxième étape, durant 15 secondes, le mélange de gaz monomères HMDSO et TMDSO est introduit avec un débit de 100 sccm pour chacun des gaz monomères de ce mélange. Les débits d'argon et d'oxygène sont augmentés jusqu'à 25 sccm pour chacun de ces gaz. La pression dans la chambre 2 est régulée avec le système de pompage à 2.10⁻² mbar. La puissance du plasma pendant cette deuxième étape est de 100 W.

Au cours d'une troisième étape, un aluminage est réalisé, pas nécessairement dans le réacteur 1, selon l'une des méthodes connues de l'homme de métier, par exemple par évaporation sur la face interne du réflecteur.

Le traitement ainsi réalisé permet d'obtenir un dépôt d'une matière polymère formant à la fois une couche améliorant la qualité spéculaire de la surface de la pièce optique et une couche barrière contre le dégazage du polymère (BMC/UP) constitutif de la pièce optique 18.

En effet, le dépôt ainsi réalisé permet de gagner 25% en flux réfléchi sur un réflecteur 18 elliptique de 60 mm de hauteur, montrant ainsi le gain en réflexion spéculaire, par rapport à une pièce optique 18 identique mais n'ayant pas subi le procédé décrit ci-dessus.

De plus, lorsque le réflecteur 18 ainsi réalisé est assemblé, pour former un projecteur, il n'apparaît pas de condensation visible de composés volatils sur la glace de ce projecteur. Alors que lorsqu'un réflecteur 18 identique mais n'ayant pas subi le procédé décrit ci-dessus, est monté dans ce type de projecteur, des zones d'opacité apparaissant sur la glace.

Le fait de mélanger HMDSO et TMDSO ensemble permet que ceux-ci réagissent ensemble lors de la polymérisation ce qui donne une couche de meilleure qualité que si l'on avait utilisé HMDSO seul.

Grâce au procédé selon l'invention, on peut utiliser des matériaux polymères pour la fabrication de pièces automobiles ayant une bonne tenue à la chaleur (BMC/UP), tout en garantissant un aspect initial irréprochable et en maintenant cet aspect au moins après 3000 heures d'utilisation (soit plusieurs années en comportement réel).

Selon un deuxième mode mise en oeuvre de l'invention, le procédé décrit ci-dessus est mis en oeuvre avec un réacteur 1 de type à plasma non diffusé. Un tel réacteur est représenté schématiquement sur la figure 2. Ce réacteur 1 comporte une chambre 2 de dépôt, un support 3 de pièces, une alimentation en gaz 4, une sortie 8 vers un système de pompage et des électrodes 10, comme celui déjà décrit. La différence essentielle avec celui déjà décrit porte sur le dispositif générateur du plasma. En effet, l'une des électrodes 10 qui le constitue est reliée à un générateur radiofréquences 11 et est placée en vis à vis du support 3 qui est relié à la masse du réacteur 1. Les gaz, entrant par l'alimentation 4 et sortant par la sortie 8 circulent essentiellement entre cette électrode 10 et le support 3. Le plasma est généré entre l'électrode 10 et le support 3. Ce plasma est non diffusé. Le procédé est réalisé dans la décharge ou à proximité de celle-ci.

Dans ce deuxième mode de mise en oeuvre de l'invention, les conditions de dépôt sont similaires à celles décrites pour le premier mode de mise en oeuvre.

Selon un troisième mode de mise en oeuvre de l'invention, le procédé est mis en oeuvre dans un réacteur ayant un applicateur à fentes rayonnantes. Un tel réacteur est décrit, par exemple, dans la demande de brevet publiée sous le numéro FR 2 693 619.

Au cours d'une première étape, durant 5 secondes, de l'argon sous un débit de 25 sccm, est introduit dans la chambre 2 pour créer un plasma micro-ondes à 2,45 GHz.

Au cours d'une deuxième étape, durant 25 secondes, un gaz monomère de HMDSO est introduit dans la chambre 2 sous un débit de 250 sccm, en même temps que de l'argon sous un débit de 25 sccm. La puissance du plasma pendant cette deuxième étape est de 700 W.

La pièce optique 18, ici le même réflecteur 18 que celui utilisé pour les modes de mise en oeuvre précédents, afin de pouvoir comparer les résultats, est aluminé au cours d'une troisième étape.

Les résultats obtenus sont proches de ceux obtenus avec les modes de mise en oeuvre précédemment décrits.

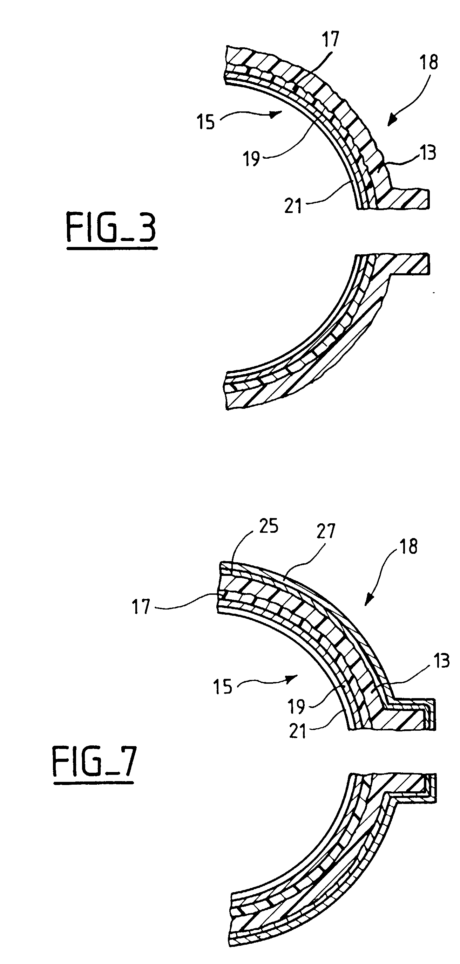

La figure 3 représente schématiquement, en coupe, un réflecteur 18 de projecteur obtenu par le premier et deuxième ou troisième mode de mise en oeuvre de l'invention, décrit ci-dessus. Ce réflecteur 18 comporte une âme 13 de BMC/UP. La face concave, ou face avant 15 de ce réflecteur 18, est recouverte d'une sous-couche 17 de polymère, destinée à améliorer la qualité spéculaire de la surface du réflecteur 18, sur sa face avant et former une couche barrière contre le dégazage. Cette sous-couche 17 est elle-même recouverte d'une couche d'aluminium 19. Cette couche d'aluminium est ensuite généralement protégée par une couche de protection 21, d'un polymère de type polysiloxane, par dépôt chimique, en phase vapeur, assisté par plasma. Ce dépôt est réalisé avec un courant continu (redressé double alternance).

D'une manière plus générale, pour les trois modes de mise en oeuvre du procédé décrits ci-dessus, les fréquences du courant alternatif délivrées par le générateur radiofréquence sont préférentiellement comprises entre 0,1 MHz et 2,45 GHz. Ce courant alternatif est pulsé ou non. Selon le mode d'amorçage du plasma, le procédé peut être mis en oeuvre dans la décharge ou à proximité de celle-ci, ou bien encore en post-décharge (plasma diffusé).

Les décharges alternatives sont préférées aux décharges en mode continu car elles sont peu sensibles à l'état des parois du réacteur 1 et des électrodes 10, elles fonctionnent bien pour les dépôts d'isolants (cas des polymères) et elles assurent un bien meilleur couplage entre les électrons et la source d'énergie.

Les réacteurs 1 tels que ceux décrits ci-dessus peuvent être équipés de dispositifs à confinement magnétique (multipolaire, magnétron, à résonnance cyclotronique ou cyclotronique répartie) des électrons afin de retarder la diffusion des électrons dans le plasma et d'augmenter ainsi l'énergie qu'ils vont créer au niveau du plasma.

D'une manière générale, le (ou les) composant(s) du gaz monomère est (sont) du type organique-siliciés, silazanes ou silanes ou bien encore hydrocarbures saturés (ou non), alyphatiques, cycliques ou aromatiques substitués (ou non) par une fonction organique (alcool, amine, ...), utilisés seuls, en mélange ou bien successivement.

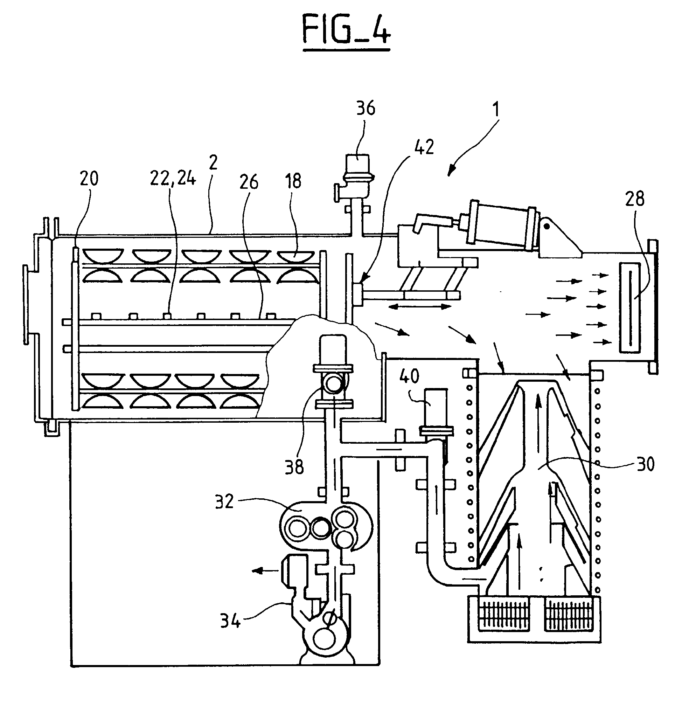

Selon un quatrième mode de mise en oeuvre du procédé selon l'invention, celui-ci consiste à réaliser une couche de blindage sur la face arrière 23 (convexe) d'un réflecteur de projecteur 18 pour un véhicule automobile. Ce procédé est par exemple mis en oeuvre avec un réacteur 1 à métalliser telle que celle schématiquement représentée sur la figure 4.

Ce réacteur 1 comporte une chambre 2 dans laquelle sont introduites des pièces optiques 18 à métalliser. Ces pièces optiques 18 sont placées sur un tambour 20. Dans la chambre 2 se trouvent également des filaments 22 et des nacelles 24, placés à proximité ou sur une barre d'effluvage 26. La chambre 2 comporte également un piège 28. La chambre 2 est reliée à un dispositif de pompage constitué d'une pompe à diffusion 30, d'une pompe ROOTS 32 et d'une pompe à palette 34.

La chambre 2 comporte également un dispositif de mise à l'air 36, une vanne primaire 38, une vanne secondaire 40 et une vanne écran 42.

Les filaments 22 et les nacelles 24 sont en tungstène. Les nacelles 24 reçoivent, pour certaines un mélange de matériaux destinés à former le blindage et pour d'autres, de l'aluminium pour former une couche réfléchissante.

Le mélange des matériaux destinés à former le blindage est constitué de 80% en poids de cuivre et de 20% en poids de chrome.

Un tambour 20 a une forme principalement cylindrique, l'axe longitudinal du cylindre étant parallèle à la barre d'effluvage 26. Le tambour 20 et mobile en rotation autour de son axe longitudinal.

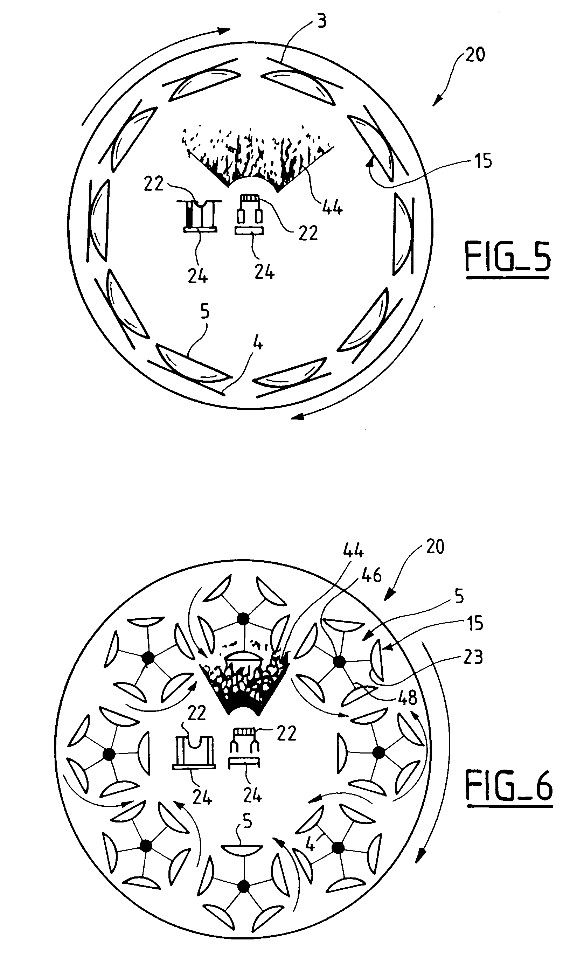

Le tambour 20 est de type à satellites ou de type planétaire. La figure 5 représente schématiquement un tambour 20 de type planétaire. La figure 6 représente schématiquement un tambour 20 à satellites.

Sur un tambour 20 de type planétaire, les pièces 18 sont disposées sur des supports 3 répartis circonférentiellement autour de la face interne de la paroi cylindrique du tambour 20.

Les pièces 18, ici encore des réflecteurs 18, peuvent être orientées, soit de manière à ce que leur face avant 15 soit principalement dirigée vers l'axe longitudinal du tambour 20, où se trouvent approximativement les nacelles 24, soit de manière à ce que leur face arrière 23 soit dirigée vers cet axe. Sur la figure 5, c'est la face avant 15 qui est orientée vers les nacelles 24.

Les filaments 22 chauffent le métal, aluminium ou mélange cuivre-chrome, contenu dans les nacelles 24 qui s'évapore et forme un cône de diffusion 44 dirigé vers une zone de la face interne de la paroi cylindrique du tambour 20. Du fait de la rotation du tambour 20, les réflecteurs 18 défilent devant le cône de diffusion 44, ce qui permet au métal de se déposer successivement sur tous les réflecteurs 18.

Sur un tambour 20 à satellites, les réflecteurs sont déposés sur des supports 3, par exemple par groupe de cinq, comme représenté sur la figure 6. Ce support 3 est constitué d'une tige 46, parallèle à l'axe longitudinal de tambour 20, à partir de laquelle s'étendent radialement des groupes de cinq rayons 48, rattachés au même niveau de la tige 46. Un réflecteur 18 est maintenu à l'extrémité de chacun des rayons 48, par sa face arrière 23. Les tiges 46, par exemple au nombre de huit, tournent sur elles-mêmes, selon leur axe longitudinal. Comme pour le tambour 20 planétaire décrit précédemment, un cône de diffusion 44 est produit à partir de nacelles 24 et de filaments 22, répartis principalement sur l'axe longitudinal du tambour 20. Grâce à un tambour 20 à satellites, non seulement les réflecteurs 18 défilent devant le cône de diffusion 44, mais ils tournent autour de l'axe des tiges 46, ce qui permet de métalliser aussi bien leur face avant 15 que leur face arrière 23.

Dans le mode de mise en oeuvre de l'invention décrit ci-dessous, le tambour 20 est de type planétaire.

Au cours d'une première étape, les réflecteurs 18 sont installés dans le tambour 20. Lors de cette installation, les réflecteurs 18 sont orientés de manière à ce que leur face arrière 23 soit dirigée vers l'axe longitudinal du tambour 20.

Au cours d'une deuxième étape, un vide est réalisé dans la chambre 2, avec effluvage à l'air.

Une fois atteinte une pression dans la chambre 2, comprise entre 5.10⁻⁵ et 10⁻⁵ mbar, on procède, au cours d'une troisième étape, à l'évaporation du mélange cuivre-chrome. La tension de vapeur du cuivre étant la plus élevée, le cuivre s'évapore en premier. La température du mélange cuivre-chrome est ensuite légèrement augmentée pour permettre au chrome de s'évaporer. Le chrome se déposant en second, il recouvre le cuivre et en assure ainsi la protection contre la corrosion.

Au cours d'une quatrième étape, les supports 3 sont tournés d'un demi-tour de manière à diriger la face avant 15 des réflecteurs 18, vers l'axe longitudinal du tambour 20.

Au cours d'une cinquième étape, on procède à l'évaporation de l'aluminium.

Enfin, au cours d'une sixième étape, on recouvre l'aluminium d'une couche 21 d'un polymère de type polysiloxanne de la même manière que celle décrite ci-dessous en relation avec la figure 3.

Ce procédé permet de réaliser un réflecteur réfléchissant assurant un blindage efficace de la source lumineuse plasma des lampes à décharge. La reprise de masse du blindage s'effectue par un contact à griffes pouvant perforer l'ensemble des couches d'aluminium et de HMDSO polymérisé, qui se sont éventuellement formées localement sur la couche de blindage.

D'une manière générale, une couche de blindage doit être suffisamment conductrice et elle doit être autoprotégée vis à vis de la corrosion. Afin de rester dans un domaine acceptable d'épaisseur pour les technologies sous vide (basses pressions) décrites ci-dessus, il est nécessaire que le matériau utilisé soit très bon conducteur électrique. Mais les matériaux conducteurs électriques sont aussi très fragiles vis à vis de la corrosion.

Préférentiellement, on déposera par co-dépôt ou par dépôts successifs un alliage ou un mélange de matériaux apportant chacun sa caractéristique spécifique.

Dans le quatrième mode de mise en oeuvre de l'invention, décrit ci-dessus, le mélange de cuivre et de chrome est constitué de 80% en poids de cuivre et 20% en poids de chrome. Mais ces pourcentages peuvent varier. En particulier, le cuivre et le chrome peuvent être en proportions égales en poids.

Par ailleurs, on effectuera préférentiellement une pulvérisation cathodique pour déposer les alliages et une évaporation par effet Joule ou par canons à électrons, pour les mélanges.

Selon un cinquième mode de mise en oeuvre du procédé selon l'invention, on réalise sur la face avant 15 de plusieurs réflecteurs 18 ayant une âme 13 en BMC/UP, une sous-couche 17 d'un polymère pour former une couche barrière contre le dégazage et améliorer la qualité spéculaire de cette face avant 15, cette couche est réalisée, par exemple, dans un réacteur à tambour 20 planétaire tel que celui décrit précédemment et conformément aux première et deuxième étapes du premier mode de mise en oeuvre de l'invention, décrit ci-dessus.

Puis une couche de blindage est réalisée, sur la face convexe des réflecteurs 18, c'est à dire sur leur face arrière 23, après rotation d'un demi tour des supports 3. Cette couche de blindage est constituée d'une couche de cuivre 25, déposée en premier, et d'une couche de chrome 27, déposée en second. Cette couche de blindage est réalisée par exemple conformément aux deuxième et troisième étapes du quatrième mode de mise en oeuvre de l'invention décrit ci-dessus.

On procède alors aux quatrième, cinquième et sixième étapes de ce même quatrième mode de mise en oeuvre pour réaliser, sur la face avant 15 du réflecteur une couche d'aluminium 19 et une couche de protection 21. Le réflecteur 18 ainsi obtenu est représenté en coupe sur la figure 8.

On comprendra que l'un des avantages majeurs de l'invention est de pouvoir réaliser un ensemble de couches en mettant en oeuvre des procédés de dépôt du même type ou compatibles, grâce à l'utilisation des technologies pour faire des couches minces, que sont le dépôt chimique en phase vapeur assisté par plasma et dépôt physique en phase vapeur. Ces procédés peuvent être mis en oeuvre sur des machines de traitement par lot, l'ensemble des opérations étant réalisé dans un même réacteur, ou bien dans une machine pas à pas, c'est à dire où les opérations sont effectuées de manière découplées, dans des réacteurs séparés, mais reliés entre eux de manière linéaire ou circulaire.

## Revendications

1. Procédé de traitement de surface de pièces optiques (18) en matière plastique pour véhicules automobiles, par dépôt sous vide à la surface des pièces (18), caractérisé par le fait que l'on dépose sous vide plusieurs matériaux, chacun conférant au dépôt formé sur la surface des pièces (18), une propriété spécifique.

2. Procédé selon la revendication 1, caractérisé par le fait que l'un des matériaux est un polymère apte à améliorer la qualité spéculaire sur au moins une zone de la surface de la matière plastique et qu'un autre des matériaux comprend un métal apte à former une surface réflectrice de la lumière, cet autre matériau étant déposé sur au moins une zone de la surface où a été déposé préalablement ledit polymère.

3. Procédé selon la revendication 1, caractérisé par le fait que l'un des matériaux est un polymère apte à former une barrière au(x) composé(s) volatil(s) de la matière plastique.

4. Procédé selon la revendication 1, caractérisé par le fait que l'un des matériaux est un polymère apte à la fois à :
- améliorer la qualité spéculaire d'au moins une zone de la surface de la matière plastique, et
- à former une barrière au(x) composé(s) volatil(s) de cette matière plastique,
ce polymère étant directement déposé sur la matière plastique et directement recouvert d'un autre matériau comprenant un métal apte à former une surface réflectrice de la lumière sur ladite zone de la surface de la matière plastique.

5. Procédé selon l'une des revendications 2 à 4, caractérisé par le fait que le polymère comprend un composé compris dans la liste constituée par les organo-siliciés, les silazanes, les silanes, les hydrocarbures saturés, les hydrocarbures non saturés, les hydrocarbures aliphatiques, cycliques ou aromatiques, les hydrocarbures substitués par une fonction alcool, les hydrocarbures substitués par une fonction amine, ainsi que les mélanges de ceux-ci.

6. Procédé selon la revendication 5, caractérisé par le fait que ledit composé est déposé seul.

7. Procédé selon la revendication 5, caractérisé par le fait que l'on dépose un mélange d'au moins deux composés compris dans la liste constitué par les organo-siliciés, les silazanes, les silanes, les hydrocarbures saturés, les hydrocarbures non saturés, les hydrocarbures substitués par une fonction alcool, les hydrocarbures substitués par une fonction amine, et les mélanges de ceux-ci.

8. Procédé selon la revendication 7, caractérisé par le fait que le mélange est composé de tétramethyldisiloxane et d'hexamethyldisiloxane.

9. Procédé selon l'une des revendications précédentes, caractérisé par le fait que l'on dépose au moins un matériau apte à constituer un blindage vis à vis des rayonnements électromagnétiques émis par une lampe à décharge.

10. Procédé selon la revendication 9, caractérisé par le fait que le matériau apte à constituer un blindage est compris dans la liste constituée par le chrome, le nickel, l'aluminium, le cuivre, un mélange d'au moins deux de ces métaux et un alliage d'au moins deux de ces métaux.

11. Procédé selon l'une des revendications précédentes, caractérisé par le fait qu'au moins deux matériaux, apportant chacun une propriété spécifique au dépôt formé sur la surface des pièces optiques, sont déposés simultanément.

12. Procédé selon l'une des revendications 1 à 10, caractérisé par le fait qu'au moins deux matériaux, apportant chacun une propriété spécifique au dépôt formé sur la surface des pièces optiques, sont déposés en couches successives.

13. Procédé selon les revendications 10 et 12, prises en combinaison, caractérisé par le fait que l'on dépose successivement une couche de cuivre, pour assurer une conductivité élevée du dépôt et une couche de chrome, pour assurer une protection contre la corrosion du cuivre.

14. Procédé selon la revendication 13, caractérisé par le fait que l'on dépose ensuite sur une zone différente de celle sur laquelle ont été réalisées les couches de cuivre et de chrome, mais présentant un recouvrement avec celle-ci, une couche d'aluminium.

15. Pièce optique en matière plastique (13) pour véhicule automobile, caractérisée par le fait qu'elle comporte une couche, déposée sous vide, de blindage vis à vis d'un rayonnement électromagnétique, constituée de deux matériaux métalliques, l'un étant apte à former essentiellement une couche électriquement conductrice (25) et l'autre (27) étant apte essentiellement à protéger la couche électriquement conductrice (25) de la corrosion.

16. Pièce optique en matière plastique (13) pour véhicule automobile, caractérisée par le fait qu'elle comporte une sous-couche (17) d'un matériau polymère déposée sous vide, directement sur la matière plastique (13), apte à améliorer la qualité spéculaire d'au moins une zone de la surface de la matière plastique (13), et une couche métallique (21) apte à former une surface réflectrice de la lumière sur ladite zone de la surface de la matière plastique (13).
